# EUROPÄISCHE PATENTSCHRIFT

(11) **EP 2 383 842 B1**
(45) Veröffentlichungstag und Bekanntmachung des Hinweises auf die Patenterteilung: **31.12.2014**
(21) Anmeldenummer: 11163843.3
(22) Anmeldetag: 27.04.2011
(51) Int. Cl.: H01R 11/28

(54) **Elektronische Vorrichtung mit Presspassverbindung**
Electronic device with press pass connection
Dispositif électronique doté d'une liaison de passage de presse

(30) Priorität: 29.04.2010 DE 102010028381
(43) Veröffentlichungstag der Anmeldung: 02.11.2011
(73) Patentinhaber: Robert Bosch GmbH, 70442 Stuttgart (DE)
(72) Erfinder: Grauf, Gerhard, 72805 Lichtenstein-Unterhausen (DE)

(56) Entgegenhaltungen:
- DE-A1- 19 738 772
- DE-A1-102004 007 851
- FR-A1- 2 879 751
- GB-A- 776 153
- GB-A- 2 067 027
- GB-A- 2 441 211
- JP-A- 9 050 868
- US-A- 5 941 735

## Beschreibung

### Stand der Technik

Die Erfindung betrifft eine elektronische Vorrichtung mit Presspassverbindung, einen Batteriesensor und ein Verfahren zur Herstellung einer derartigen elektronischen Vorrichtung.

Die US 5941735 beschreibt einen Isolationskörper mit zwei Kontakten und einer Öffnung, in die eine Sicherung eingebracht wird, deren Kontaktenden zwischen Federn der Kontakte, die im Isolationskörper befestigt sind, eingespannt sind.

Mit Batteriesensoren wird die Restladung von Batterien bestimmt. Sie sind beispielsweise in DE 10 2006 019 895 A1 beschrieben. Danach wird der aus der Batterie abfließende elektrische Strom über einen niederohmigen elektrischen Widerstand, auch Nebenschlusswiderstand oder Shunt genannt gemessen, aus dem dann die Restladung der Batterie rechnerisch bestimmt wird. Die Berechnung erfolgt in einer Schaltung auf einer Leiterplatte, die über Verbindungselemente an den Shunt angeschlossen wird. Dabei können die Verbindungselemente sowohl in Bohrungen der Leiterplatte als auch in Bohrungen des Shuntes eingepresst sein. Dieser Aufbau ermöglicht es zwar die Leiterplatte mit dem Shunt gleichzeitig mechanisch und elektrisch sicher zu kontaktieren, ohne dass zur elektrischen Kontaktierung eine größere thermische Beanspruchung der Elemente notwendig wäre, jedoch bedingen die Verbindungselemente für jede Verbindung zwischen Leiterplatte und Shunt zwei verschiedene Kontaktpunkte, die einerseits einen erhöhten Fertigungsaufwand bedeuten und andererseits auch den Kontaktwiderstand zwischen Leiterplatte und Shunt erhöhen, der das Messergebnis verfälscht.

Zur Vermeidung dieses doppelten Kontaktes wurde ein Aufbau vorgeschlagen, bei dem die Leiterbahnen wenigstens an der Kontaktstelle zwischen Leiterplatte und Shunt bis auf die Unterseite der Leiterplatte geführt sind und so über eine Lötverbindung mit dem Shunt elektrisch und mechanisch kontaktiert werden können. Dies hat zwar den Vorteil, dass die Leiterplatte über nur noch einen einzigen Kontakt am Shunt kontaktiert werden kann und so die oben genannten Nachteile vermieden werden, der Lötprozess selbst stellt jedoch einige fertigungstechnische Probleme dar. Zunächst müssen die Flächen für die Lötstelle auf dem Shunt und an der Leiterplatte rein sein, da jede Verunreinigung den Kontaktwiderstand erhöht. Der Lötprozess selbst muss genau abgestimmt sein, denn nicht nur Flussmittelreste aus der Lotpaste sondern auch ein übermäßiger Wärmeeintrag können das Produkt schädigen. Auch kann die Leiterplatte beim Löten auf dem Shunt verschwimmen und so deplaziert werden.

Bei einer elektrischen und mechanischen Verbindung zwischen einer Leiterplatte und einem Shunt ist es somit erwünscht, die Zahl der elektrischen und mechanischen Kontakte pro Verbindung zwischen Leiterplatte und Shunt zu verringern und den Fertigungsprozess so einfach wie möglich zu gestalten.

### Offenbarung der Erfindung

Die erfindungsgemäße Vorrichtung ersetzt die Lötstelle aus dem Stand der Technik durch einen einstückig mit dem Shunt ausgebildeten Stecker. Der Vorteil der Erfindung ist, dass ein Verschwimmen und damit eine Deplatzierung der Leiterplatte auf dem Shunt durch den Lötprozess ausgeschlossen sind. Jede Verbindung zwischen Leiterplatte und Shunt benötigt trotzdem nur einen einzigen Kontakt, der gleichzeitig die mechanische und die elektrische Verbindung zwischen Leiterplatte und Shunt gewährleistet. So wird nicht nur der ohmsche elektrische Kontaktwiderstand zwischen Leiterplatte und Shunt sondern auch die Zahl der notwendigen Fertigungsschritte bei der Herstellung verringert, da nicht nur weniger Arbeitsschritte zum Kontaktieren selbst sondern auch weniger vorzufertigende Bauteile notwendig sind. Die erfindungsgemäße Vorrichtung umfasst ein Bauteil mit einem elektrischen Schaltkreis und einer Bauteilöffnung sowie einen elektrisch leitfähigen Massivkörper, der einen einstückig mit dem Massivkörper ausgebildeten Stecker aufweist, über den der Massivkörper und der Schaltkreis in elektrischem Kontakt miteinander stehen. Dabei sind der Stecker und das Bauteil über die Bauteilöffnung mittels einer kraft- und/oder formschlüssigen Verbindung miteinander verbunden.

Die Unteransprüche zeigen bevorzugte Weiterbildungen der Erfindung.

In einer bevorzugten Ausführung der Erfindung kann die kraftschlüssige Verbindung eine Presspassung in der Bauteilöffnung zwischen dem Stecker und dem Bauteil sein. Auf diese Weise ist die Verbindung dauerhaft beständig selbst gegen höhere Belastungen. Ferner wird gleichzeitig ein sicherer elektrischer Kontakt gewährleistet.

In einer weiteren bevorzugten Ausführungsform der Erfindung kann die Bauteilöffnung durchgehend durch das Bauteil ausgebildet sein, so dass die Pressverbindung keine Spannungen auf die Oberfläche des Bauteils auf der gegenüberliegenden Seite der Bauteilöffnung aufbauen kann.

In einer alternativen oder zusätzlichen Ausbildung der Erfindung kann für die formschlüssige Verbindung ein Endbereich des Steckers derart angeordnet sein, dass der Endbereich eine Oberfläche des Bauteils berührt. Auf diese Weise kann die elektrische Verbindung zwischen Leiterplatte und Shunt einfach durch umbiegen und Kontaktieren des Endbereichs des Steckers mit dem Schaltkreis erreicht werden.

In einer weiteren bevorzugten Ausführung der Erfindung kann der Stecker an seiner Stirnseite eine Vertiefung aufweisen. Mittels der Vertiefung kann vorzugsweise noch ein Verstemmen des Steckers an der Bauteilöffnung erfolgen. Soll der Stecker über eine optionale Lötverbindung an eine Leiterbahn des Schaltkreises kontaktiert werden, so bietet die Vertiefung eine zusätzliche Fläche, um den Kontakt zwischen Lot und Stecker mechanisch beständiger und elektrisch niederohmiger auszugestalten.

Diese Vertiefung kann in einer Weiterbildung der Erfindung eine Durchgangsöffnung durch den Massivkörper sein und so zur Senkung von Spannungen im Massivkörper beitragen. Alternativ ist die Vertiefung ein Sackloch.

Die Durchgangsöffnung kann sich in einer weiteren Weiterbildung der Erfindung insbesondere von einer dem Stecker gegenüberliegenden Seite des Massivkörpers aus verjüngen. Auf diese Weise bietet die Durchgangsöffnung einen guten Halt für die elastische Gussmasse.

In einer anderen Ausbildung der Erfindung kann die Vertiefung an der Stirnseite des Steckers aufgeweitet sein. Dies würde eine alternative oder zusätzliche Befestigungsmöglichkeit des Bauteils am Massivkörper über den Stecker bieten. Insbesondere könnte das Bauteil so doppelt abgesichert werden, so dass sich das Bauteil selbst bei einer fehlerhaft gefertigten Presspassung nicht vom Massivkörper löst.

Der Massivkörper kann einen elektrischen Nebenschlusswiderstand für den Schaltkreis aufweisen und so nicht nur als Halteelement dienen sondern auch eine Funktion als elektrisches Bauteil übernehmen.

In einer besonderen Ausbildung kann in der Draufsicht auf die Vorrichtung eine Fläche des Massivkörpers gleich groß oder größer sein, als eine Fläche des Bauteils. Die Dimension des Massivkörpers ist so ausreichend groß, um ihn in Reihe zwischen einem Batteriepol und einem Verbraucher als Stromaufnehmer zur Messung des aus der Batterie abgegebenen Stromes zu nutzen, so dass eine messbare Spannung abfällt, ohne spürbar großen Verlustleistungen zu erzeugen.

In einer anderen Ausführung der Erfindung kann der Stecker einen dreieckigen, viereckigen oder runden Querschnitt aufweisen. Ein Stecker mit eckigem Querschnitt sichert die Lage des Massivkörpers gegen das Bauteil auch gegen ein Verdrehen beider Elemente zueinander, während sich ein Stecker mit einem runden Querschnitt durch Drehbewegungen gut in die Bauteilöffnungen einführen lässt.

In die Vertiefung kann in einer vorteilhaften Ausbildung eine elastische Gussmasse eingegossen sein und so die Verbindungsstelle zwischen Massivkörper und Bauteil vor Verunreinigungen schützen.

In einer zusätzlichen oder alternativen Weiterbildung der Erfindung können der Massivkörper mit dem Stecker und das elektrische Bauteil wenigstens teilweise oder vollständig von der elastischen Gussmasse umgeben sein. Auf diese kann der Schutz vor Verunreinigungen von wichtigen Bauteilen bis auf die gesamte Vorrichtung hin ausgedehnt werden.

In einer alternativen oder zusätzlichen Ausbildung können der Stecker und/oder die Bauteilöffnung mit Schneiden versehen sein. Diese verbessert die elektrische Kontaktierung mit dem Bauteil in der Bauteilöffnung.

In einer bevorzugten Ausführungsform der Erfindung kann die Leiterbahn des Schaltkreises, die mit dem Shunt zu kontaktieren ist, in die Bauteilöffnung eingeführt sein. Dies hat den Vorteil, dass in Verbindung mit der Presspassung der Prozess des Lötens und Reinigens komplett entfällt. Auch die Flussmittelreste aus der Lötpaste und ein übermäßiger Wärmeeintrag auf das Produkt entfallen. Das Lot wird nicht benötigt. Somit kann auch keine stoffschlüssige Verbindungslücke zwischen Lot und der Kontaktstellen auf dem Shunt und/oder der Leiterplatte, sogenannte kalte Lötstellen entstehen.

Die Erfindung gibt auch einen elektronischen Batteriesensor an, der eine erfindungsgemäße Vorrichtung umfasst. Dabei kann der Massivkörper einen Nebenschlusswiderstand aufweisen und der Schaltkreis einen Ladestand einer mit dem elektronischen Batteriesensor verbundenen Batterie basierend auf einem erfassten elektrischen Strom durch den Nebenschlusswiderstand bestimmen. Ein derartiger Batteriesensor ist durch die robuste mechanische und elektrische Verbindung zwischen Massivkörper und Bauteil sehr ausfallsicher selbst bei extremen Erschütterungen. Daher ist der erfindungsgemäße elektronische Batteriesensor hervorragend zum Messen des Ladestandes einer Kraftfahrzeugbatterie selbst während der Fahrt geeignet.

Die Erfindung gibt auch ein Verfahren zum Herstellen einer Vorrichtung an, die einen elektrisch leitfähigen Massivkörper und ein Bauteil mit einem elektrischen Schaltkreis und einer Bauteilöffnung umfasst. In diesem Verfahren wird zunächst das den Schaltkreis tragende Bauteil mit der Bauteilöffnung und dann der Massivkörpers mit einem einstückig vom Massivkörper vorstehenden Stecker ausgebildet. Schließlich wird das Bauteil mit dem Massivkörper über eine kraftschlüssige Verbindung, insbesondere Pressverbindung und/oder über eine formschlüssige Verbindung zwischen dem Bauteil und dem Stecker über die Bauteilöffnung verbunden. Vorteilhaft an diesem Herstellungsverfahren ist, dass der Stecker parallel bei der Herstellung des Shunts angefertigt werden kann, was insbesondere in der Massenproduktion wichtige Prozesszeit einspart.

### Kurze Beschreibung der Zeichnungen

Nachfolgend werden den Schutzbereich nicht einschränkende Ausführungsbeispiele der Erfindung unter Bezugnahme auf die begleitenden Zeichnungen im Detail beschrieben. In der Zeichnung ist:
- Figur 1: eine Schnittdarstellung eines ersten Ausführungsbeispiels für eine erfindungsgemäße Vorrichtung;
- Figur 2: eine Schnittdarstellung eines zweiten Ausführungsbeispiel für eine erfindungsgemäße Vorrichtung;
- Figur 3: eine Schnittdarstellung eines dritten Ausführungsbeispiel für eine erfindungsgemäße Vorrichtung;
- Figur 4: eine Darstellung eines Ausführungsbeispiel für einen erfindungsgemäßen Batteriesensor in der Draufsicht; und
- Figur 5: ein Ablaufdiagramm eines Ausführungsbeispiel für ein erfindungsgemäßes Verfahren.

### Ausführungsformen der Erfindung

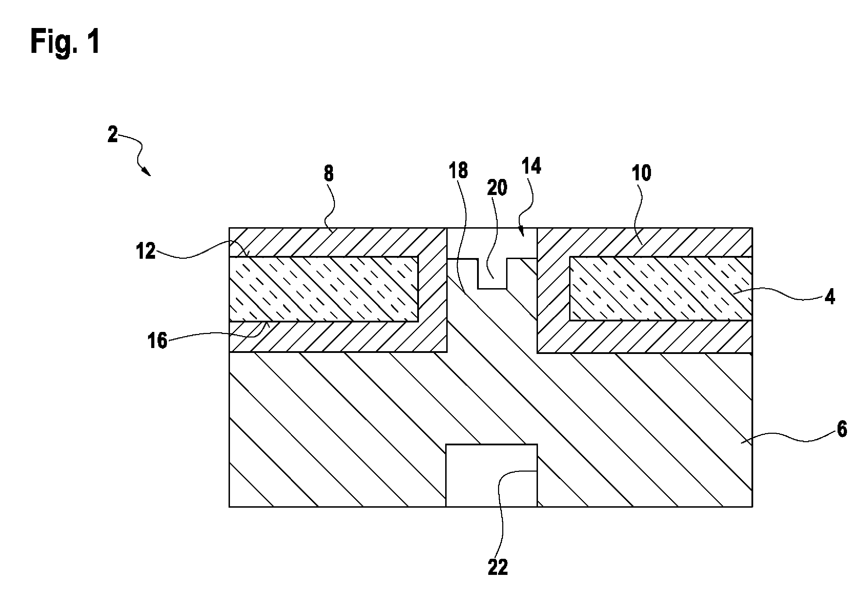

In Figur 1 ist ein erstes Ausführungsbeispiel für eine erfindungsgemäße Vorrichtung 2 im Schnitt dargestellt. Diese Darstellung ist zum besseren Verständnis nicht maßstabsgetreu. Die Vorrichtung 2 umfasst ein Bauteil in Form einer Leiterplatte 4 und einen Massivkörper in Form eines Shunts 6.

Die Leiterplatte 4 weist Leiterbahnen 8, 10 auf, die entlang einer Oberseite 12 der Leiterplatte 4 verlaufen und in eine Leiterplattenöffnung 14 münden. Dort erstrecken Sie sich entlang der Wand der Leitplattenöffnung 14 und treten aus dieser an der Unterseite 16 der Leiterplatte 4 wieder aus, wo sie dann weiterverlaufen.

Der Shunt 6 weist einen einstückig mit dem Shunt ausgebildeten Stecker 18 auf, der in die Leiterplattenöffnung 14 eingeführt ist und mit dieser mittels einer Presspassung verbunden ist. Die Formen des Steckers 18 und entsprechend der Leiterplattenöffnung 14 können im Querschnitt rund oder eckig sein. Auf diese Weise wird ein elektrischer Kontakt zwischen den Leiterbahnen 8, 10 und dem Shunt 6 sowie ein mechanischer Kontakt zwischen der Leiterplatte 4 und dem Shunt 6 hergestellt und gehalten. Um den Kontakt zwischen Shunt 6 und Leiterbahnen 8, 10 zu verbessern kann der Stecker 18 mit Schneiden versehen sein, mit denen er sich in das Material der Leiterbahnen 8, 10 hineinschneiden kann. Der Stecker 18 ist in der Leiterplattenöffnung 14 vollständig versenkt angeordnet. Auf der Oberseite des Steckers 18 ist eine Vertiefung 20 in den Shunt 6 hinein ausgebildet. Auf der Unterseite des Shunts 6 ist gegenüber dem Stecker eine Ausnehmung 22 ausgebildet.

Zur weiteren Sicherung der Presspassung kann insbesondere die elektrische Kontaktierung auch mit einem nicht gezeigten Lot erfolgen, das die Leiterplattenöffnung 14 verschließt und sich teilweise über die Leiterbahnen 8, 10 auf der Oberfläche 12 der Leiterplatte 4 erstreckt. In diesem Fall ist die Vertiefung 10 besonders günstig, da sie eine breite elektrische und mechanische Kontaktfläche für das Lot bietet. Auch brauchen in diesem Fall die Leiterbahnen 8, 10 nicht in die Leiterplattenöffnungen 14 eingeführt zu werden, da das Lot die elektrische Kontaktierung zum Shunt 6 sicherstellt.

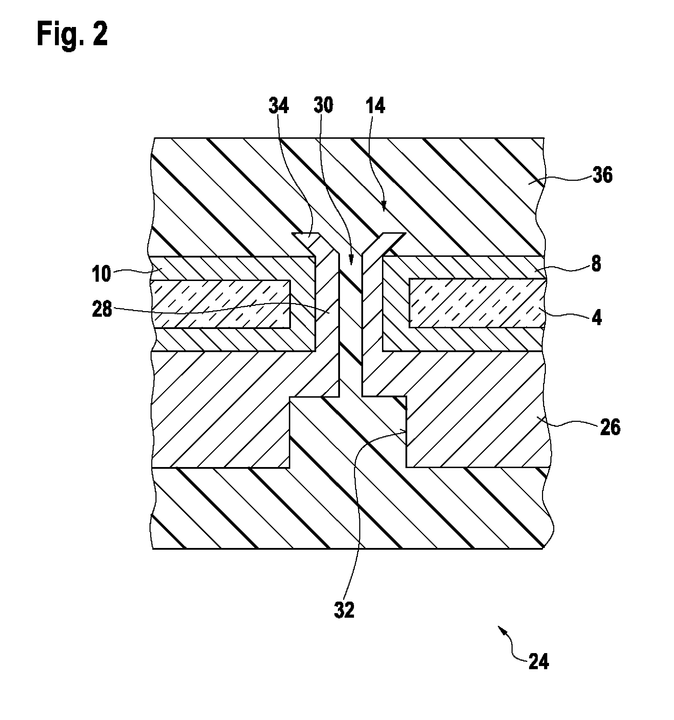

In Figur 2 ist ein zweites Ausführungsbeispiel für eine erfindungsgemäße Vorrichtung 24 im Schnitt dargestellt. Gleiche beziehungsweise funktional gleiche Teile sind mit den gleichen Bezugszeichen wie im ersten Ausführungsbeispiel bezeichnet. Auch diese Darstellung ist zur verständlicheren Darstellung nicht maßstabgetreu. Die Vorrichtung 24 des zweiten Ausführungsbeispiels umfasst die Leiterplatte 4 mit Leiterbahnen 8, 10 und einer Leiterplattenöffnung 14.

Die Leiterplatte 4 ist auf einen Shunt 26 aufgesetzt und wird von diesen getragen. Der Shunt 26 weist einen Stecker 28 auf, der die Form des Steckers 18 des ersten Ausführungsbeispiels aufweisen kann, durch die Leiterplattenöffnung 14 geführt ist und mit dieser eine Presspassung bildet. Der Stecker 28 weist eine Durchgangsbohrung 30 durch den Stecker 28 und durch den Shunt 26 auf. Am Shunt 26 auf der gegenüberliegenden Seite des Steckers 28 ist eine Ausnehmung 32 vorhanden, die einen größeren Querschnitt als die Durchgangsbohrung 30 aufweist. Der obere Bereich 34 des Steckers 28 ragt ferner über die Leiterplatte 4 hinaus. In diesem Bereich 34 kann die Durchgangsbohrung 30 beispielsweise mit einem Dorn aufgeweitet werden, um den Halt der Leiterplatte 4 am Shunt 26 zu verbessern. Diese Aufweitung kann auch alternativ zur Presspassung die elektrische und mechanische Kontaktierung zwischen Shunt 26 und Leiterplatte 4 herstellen.

Wie beispielhaft in der Figur 2 gezeigt, können die Vorrichtungen 2, 24 des ersten und zweiten Ausführungsbeispiels von einer elastischen Gussmasse 36 umgeben sein, die die Vorrichtungen 2, 24 beispielsweise vor Verschmutzung schützt. Durch die Vertiefung 20 und die Ausnehmung 22 oder entsprechend durch die Durchgangsbohrung 30 und die Ausnehmung 32 wird die Lage der Gussmasse 36 fixiert. Auch kann die Vertiefung 20 des ersten Ausführungsbeispiels für eine bessere Fixierung der Gussmasse 36 als Durchgangsbohrung ausgeführt sein.

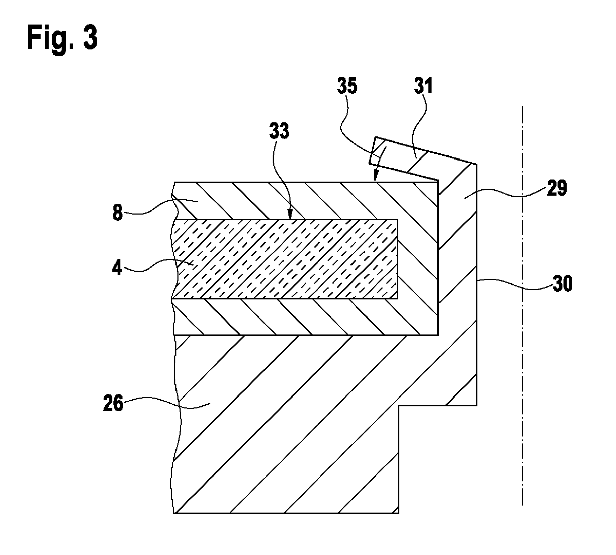

In Figur 3 ist ein drittes Ausführungsbeispiel für die Vorrichtung 24 aus Figur 2 im Schnitt dargestellt. Gleiche beziehungsweise funktional gleiche Teile sind mit den gleichen Bezugszeichen wie im ersten und zweiten Ausführungsbeispiel bezeichnet und werden nicht noch einmal beschrieben. Auch diese Darstellung ist zur verständlicheren Darstellung nicht maßstabgetreu.

Im dritten Ausführungsbeispiel weist der Shunt 26 der Vorrichtung 24 aus Figur 2 einen Stecker 29 auf. Ein Endbereich 31 des Steckers 29 ist gegen die Oberfläche 33 der Leiterplatte 4 derart gebogen (Pfeil 35), dass der Endbereich 31 eine der Leiterbahnen 8, 10 berührt und kontaktiert. Auf diese Weise wird die Leiterplatte 4 zwischen dem Endbereich 31 des Steckers 29 und dem Shunt 26 eingeklemmt und gehalten, so dass eine formschlüssige Verbindung hergestellt ist. Ist an der Berührungsstelle des Endbereichs 31 des Steckers 29 keine Leiterbahn 8, 10 vorhanden, so kann der Endbereich 31 des Steckers 29 die Oberfläche 33 der Leiterplatte 4 auch direkt berühren.

Der Endbereich 31 des Steckers 29 kann zum Biegen speziell vorbereitet werden. Dazu kann der Endbereich 31 beispielsweise eine in der Figur 3 nicht gezeigte vom Stecker 29 abragende Nase sein.

Der Stecker 29 des dritten Ausührungsbeispiels kann zur Unterstützung des Steckers 28 aus Figur 2 vorgesehen sein. Alternativ kann der Stecker 29 auch allein die Leiterbahnen 8, 10 mit dem Shunt 26 elektrisch sowie die Leiterplatte 4 mit dem Shunt 26 mechanisch kontaktieren. Es ist ebenfalls möglich, dass einer der beiden Stecker 28, 29 die elektrische Kontaktierung und der andere Stecker 28, 29 die mechanische Kontaktierung übernimmt.

Die Verwendung des Steckers 29 aus Figur 3 wurde im Zusammenhang mit Figur 2 beschrieben. Dies ist jedoch nicht einschränkend. In gleicher Weise kann der Stecker 29 aus Figur 3 auch zusammen mit dem Stecker 18 aus Figur 1 zur Unterstützung der zuvor beschriebenen elektrischen und/oder mechanischen Kontaktierung verwendet werden. Der Endbereich 31 kann eine oder mehrere vorstehende Nasen aufweisen oder als umlaufender Kragen vorgesehen werden.

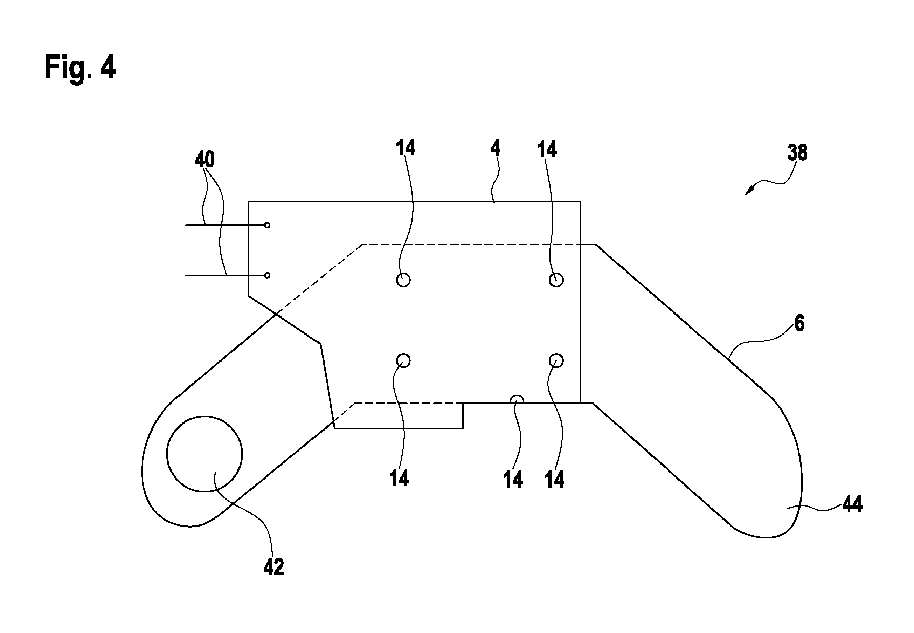

In Figur 4 ist ein Ausführungsbeispiel für einen erfindungsgemäßen Batteriesensor 38 in der Draufsicht dargestellt.

Der Batteriesensor 38 weist eine der zuvor beschriebenen Vorrichtungen 2, 24 auf. Die Leiterplatte 4 ist dabei nur in ihren Umrissen mit fünf Leiterplattenöffnungen 14 dargestellt, durch welche die Stecker 18, 28, 29 des Shunts 6 geführt sind. Eine der Leiterplattenöffnungen 14 ist dabei am Rand der Leiterplatte 4 angeordnet und weist eine halbzylindrische Form auf. Durch die Stecker 18, 28, 29 wird der nicht gezeigte Schaltkreis der Leiterplatte 4 elektrisch mit dem Shunt 6 verbunden und kann so einen Spannungsabfall am Shunt 6 messen. Das Volumen des Shunts 6 ist so dimensioniert, dass der Spannungsabfall zwar messbar groß, jedoch nicht so groß wird dass er zu einem unerwünscht hohen Verlustwiderstand führt. Mit diesem Spannungsabfall kann schließlich der Strom durch den Shunt 6 und die Ladung einer an den Shunt 6 angeschlossenen nicht gezeigten Batterie bestimmt und beispielsweise über Anschlüsse 40 an eine weitere Prozesseinheit ausgegeben werden. Die Fläche des Shunts 6 ist in der Draufsicht größer als eine Fläche der Leiterplatte 4.

Zum Anschluss an die Batterie weist der Shunt 6 an einer Seite neben der Schaltung eine Durchgangsbohrung 42 auf, in die der Anschlussstecker der Batterie eingeführt wird. Auf der anderen Seite 44 des Shunts kann dann ein nicht gezeigter Verbraucher angeschlossen werden. Der Anschluss kann mit Klemmen oder Schraubzwingen erfolgen. Alternativ kann auch eine weitere Durchgangsbohrung vorgesehen sein.

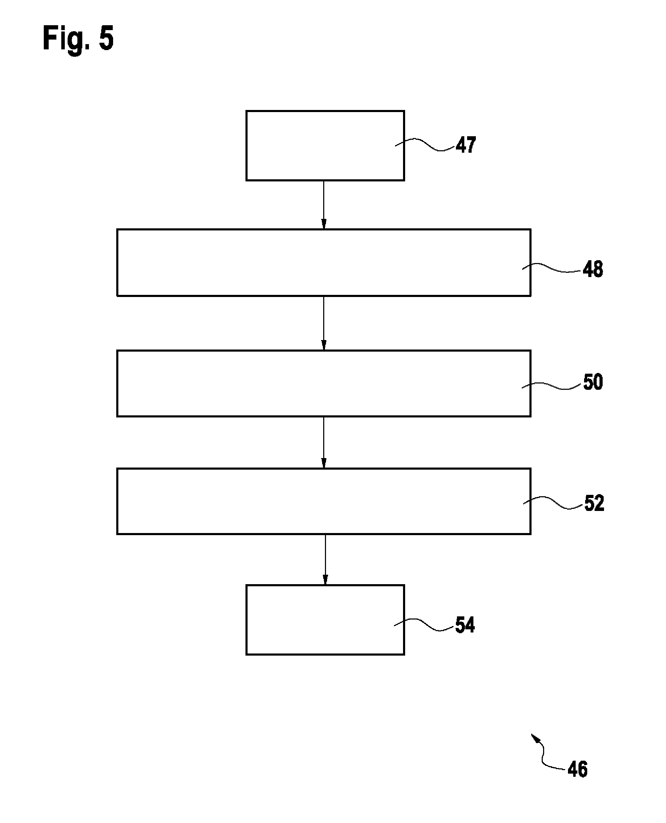

In Figur 5 ist ein Diagramm eines Ausführungsbeispiels für ein erfindungsgemäßes Verfahren 46 zur Herstellung der erfindungsgemäßen Vorrichtung 2, 24 dargestellt.

Danach wird nach dem Start 47 zunächst im ersten Schritt 48 die Leiterplatte 4 mit der Leiterplattenöffnung 14 gefertigt. Im zweiten Schritt 50 wird der Shunt 6, 26 mit dem Stecker 18, 28 gefertigt. Die Reihenfolge der Schritte 48 und 50 ist beliebig austauschbar. Schließlich wird im Schritt 52 zum Verbinden des Shunts 6, 26 mit der Leiterplatte 4 der Stecker 18, 28 in die Leiterplattenöffnung 14 eingeführt, durch eine kraftschlüssige Verbindung fixiert und ein elektrischer Kontakt hergestellt. Damit ist das Verfahren beendet (Schritt 54).

In allen beschriebenen Ausführungsbeispielen wird somit an einem elektrisch leitfähigen Massivkörper ein einstückig mit dem Massivkörper ausgebildeter Stecker vorgesehen und in eine Bauteilöffnung eines Bauteils mit einem elektrischen Schaltkreis eingeführt. Auf diese Weise kann der Stecker zur elektrischen und gleichzeitigen mechanischen Kontaktierung des Massivkörpers an das Bauteil und den Schaltkreis verwendet werden. Der Stecker und das Bauteil können über die Bauteilöffnung formschlüssig und/oder kraftschlüssig beispielsweise mittels einer Presspassung verbunden sein.

## Patentansprüche

1. Vorrichtung umfassend:
- ein Bauteil (4), insbesondere eine Leiterplatte, mit einem elektrischen Schaltkreis (8, 10) und einer Bauteilöffnung (14) und
- einen elektrisch leitfähigen Massivkörper (6, 26), insbesondere einen Shunt, der einen Stecker (18, 28, 29) aufweist, über den der Massivkörper (6, 26) und der Schaltkreis (8, 10) in elektrischem Kontakt miteinander stehen,
- wobei der Stecker (18, 28, 29) und das Bauteil (4) über die Bauteilöffnung (14) mittels einer kraft- und/oder formschlüssigen Verbindung verbunden sind, **dadurch gekennzeichnet, dass** der Stecker einstückig mit dem Massivkörper ausgebildet ist, und dass das Bauteil (4) auf den Massivkörper (6, 26) aufgesetzt ist und von diesem getragen wird.

2. Vorrichtung nach Anspruch 1, wobei die kraftschlüssige Verbindung eine Presspassung in der Bauteilöffnung (14) zwischen dem Stecker (18, 28, 29) und dem Bauteil (4) ist.

3. Vorrichtung nach einem der vorstehenden Ansprüche, wobei die Bauteilöffnung (14) durchgehend durch das Bauteil (4) ausgebildet ist.

4. Vorrichtung nach Anspruch 3, wobei der Stecker (18, 28,29) durch die Bauteilöffnung (14) geführt ist.

5. Vorrichtung nach Anspruch 4, wobei ein Endbereich (31) des Steckers (16, 28, 29) über das Bauteil (4) hinausragt.

6. Vorrichtung nach Anspruch 5, wobei für die formschlüssige Verbindung ein Endbereich (31) des Steckers (29) derart angeordnet ist, dass der Endbereich eine Oberseite des Bauteils (4) oder einen auf dieser Oberseite (33) angeordneten Schaltkreis (8, 10) berührt.

7. Vorrichtung nach Anspruch 6, wobei das Bauteil (4) zwischen dem Endbereich (31) des Steckers (29) und dem Massivkörper (26) eingeklemmt ist.

8. Vorrichtung nach einem der Ansprüche 5 bis 7, wobei der Endbereich (31) eine vom Stecker (29) abragende Nase oder einen vom Stecker abragenden Kragen aufweist.

9. Vorrichtung nach einem der vorstehenden Ansprüche, wobei der Stecker (18, 28, 29) an seiner Stirnseite eine Vertiefung (20, 30) aufweist.

10. Vorrichtung nach Anspruch 9, wobei die Vertiefung (20, 30) eine Durchgangsöffnung (30) durch den Massivkörper (6, 26) ist.

11. Vorrichtung nach Anspruch 10, wobei die Durchgangsöffnung (30) sich verjüngend, insbesondere von einer dem Stecker (18, 28) gegenüberliegenden Seite des Massivkörpers (6, 26) aus, vorgesehen ist.

12. Vorrichtung nach einem der Ansprüche 9 bis 11, wobei die Vertiefung (20, 30) an der Stirnseite des Steckers aufgeweitet ist.

13. Vorrichtung nach einem der Ansprüche 9 bis 12 umfassend eine in die Vertiefung (20, 30) eingegossene elastische Gussmasse (36).

14. Vorrichtung nach Anspruch 13, wobei der Massivkörper (6, 26) mit dem Stecker (18, 28) und das elektrische Bauteil (4) wenigstens teilweise von der elastischen Gussmasse (36) umgeben sind.

15. Vorrichtung nach einem der vorstehenden Ansprüche, wobei der Massivkörper (6, 26) ein elektrischer Nebenschlusswiderstand für den Schaltkreis ist.

16. Vorrichtung nach einem der vorstehenden Ansprüche, wobei in der Draufsicht auf die Vorrichtung (2, 24) eine Fläche des Massivkörpers (6, 26) gleich groß oder größer ist, als eine Fläche des Bauteils (4).

17. Vorrichtung nach einem der vorstehenden Ansprüche, wobei der Stecker (18, 28) eine Volumenform mit Schneidcharakter aufweist.

18. Elektronischer Batteriesensor umfassend
- eine Vorrichtung (2, 24) nach einem der vorstehenden Ansprüche, wobei
- der Massivkörper (6, 26) einen Nebenschlusswiderstand aufweist und
- der Schaltkreis (8, 10) zum Bestimmen eines Ladestandes einer mit dem elektronischen Batteriesensor (38) verbundenen Batterie basierend auf einem erfassten elektrischen Strom durch den Nebenschlusswiderstand vorgesehen ist.

19. Verfahren zum Herstellen einer Vorrichtung (2, 24) gemäss Anspruch 1, umfassend einen elektrisch leitfähigen Massivkörper (6, 26) und ein Bauteil (4) mit einem elektrischen Schaltkreis (8, 10) und einer Bauteilöffnung (14) mit den Schritten:
- Ausbilden (48) des den Schaltkreis (8, 10) tragenden Bauteils (4) mit der Bauteilöffnung (14);
- Ausbilden (50) des Massivkörpers (6, 26) mit einem einstückig vom Massivkörper (6, 26) vorstehenden Stecker (18, 28, 29); und
- Verbinden (52) des Bauteils (4) mit dem Massivkörper (6, 26) über eine kraftschlüssige Verbindung, insbesondere Pressverbindung und/oder über eine formschlüssige Verbindung zwischen dem Bauteil (4) und dem Stecker (18, 28, 29) über die Bauteilöffnung (14).

## Claims

1. Apparatus comprising:
- a component (4), in particular a printed circuit board, having an electrical circuit (8, 10) and a component opening (14), and
- an electrically conductive solid body (6, 26), in particular a shunt, which has a plug (18, 28, 29) by means of which the solid body (6, 26) and the electrical circuit (8, 10) are in electrical contact with one another,
- wherein the plug (18, 28, 29) and the component (4) are connected by means of a force-fitting and/or interlocking connection via the component opening (14), **characterized in that** the plug is integrally formed with the solid body, and **in that** the component (4) is mounted onto the solid body (6, 26) and is carried by it.

2. Apparatus according to Claim 1, wherein the force-fitting connection is a press-fit in the component opening (14) between the plug (18, 28, 29) and the component (4).

3. Apparatus according to either of the preceding claims, wherein the component opening (14) is formed continuously through the component (4).

4. Apparatus according to Claim 3, wherein the plug (18, 28, 29) is guided through the component opening (14).

5. Apparatus according to Claim 4, wherein an end region (31) of the plug (16, 28, 29) projects beyond the component (4).

6. Apparatus according to Claim 5, wherein, for the interlocking connection, an end region (31) of the plug (29) is arranged in such a way that the end region touches an upper face of the component (4) or a circuit (8, 10) which is arranged on the said upper face (33).

7. Apparatus according to Claim 6, wherein the component (4) is clamped in between the end region (31) of the plug (29) and the solid body (26).

8. Apparatus according to one of Claims 5 to 7, wherein the end region (31) has a lug which projects away from the plug (29) or a collar which projects away from the plug.

9. Apparatus according to one of the preceding claims, wherein the plug (18, 28, 29) has a recess (20, 30) at its end face.

10. Apparatus according to Claim 9, wherein the recess (20, 30) is a passage opening (30) through the solid body (6, 26).

11. Apparatus according to Claim 10, wherein the passage opening (30) is provided in a tapering fashion, in particular from a side of the solid body (6, 26) which is situated opposite the plug (18, 28).

12. Apparatus according to one of Claims 9 to 11, wherein the recess (20, 30) is widened at the end face of the plug.

13. Apparatus according to one of Claims 9 to 12, comprising an elastic casting compound (36) which is poured into the recess (20, 30).

14. Apparatus according to Claim 13, wherein the solid body (6, 26) together with the plug (18, 28) and the electrical component (4) are at least partially surrounded by the elastic casting compound (36).

15. Apparatus according to one of the preceding claims, wherein the solid body (6, 26) is an electrical shunt resistor for the circuit.

16. Apparatus according to one of the preceding claims, wherein, in a plan view of the apparatus (2, 24), an area of the solid body (6, 26) is equal to or greater than an area of the component (4).

17. Apparatus according to one of the preceding claims, wherein the plug (18, 28) has a three-dimensional shape with a cutting character.

18. Electronic battery sensor, comprising
- an apparatus (2, 24) according to one of the preceding claims, wherein
- the solid body (6, 26) has a shunt resistor, and
- the circuit (8, 10) is intended to determine a state of charge of a battery, which is connected to the electronic battery sensor (38), on the basis of a detected electric current through the shunt resistor.

19. Method for producing an apparatus (2, 24) according to Claim 1, comprising an electrically conductive solid body (6, 26) and a component (4) having an electrical circuit (8, 10) and a component opening (14), comprising the steps of:
- forming (48) the component (4), which carries the circuit (8, 10), with the component opening (14);
- forming (50) the solid body (6, 26) with a plug (18, 28, 29) which extends integrally from the solid body (6, 26); and
- connecting (52) the component (4) to the solid body (6, 26) by means of a force-fitting connection, in particular a press connection and/or by means of an interlocking connection between the component (4) and the plug (18, 28, 29) via the component opening (14).

## Revendications

1. Ensemble comprenant :
un composant (4), en particulier une carte de circuit, qui présente un circuit électrique (8, 10) et une ouverture (14) dans le composant et
un corps massif (6, 26) électriquement conducteur, en particulier un shunt, qui présente une fiche (18, 28, 29) par laquelle le corps massif (6, 26) et le circuit (8, 10) sont mis en contact électrique mutuel,
la fiche (18, 28, 29) et le composant (4) étant reliés par l'intermédiaire de l'ouverture (14) du composant au moyen d'une liaison en correspondance mécanique et/ou en correspondance géométrique, **caractérisé en ce que**
la fiche est formée d'un seul tenant avec le corps massif et
**en ce que** le composant (4) est placé sur le corps massif (6, 26) et est porté par ce dernier.

2. Ensemble selon la revendication 1, dans lequel la liaison en correspondance mécanique est un ajustement comprimé entre la fiche (18, 28, 29) et le composant (4) dans l'ouverture (14) du composant.

3. Ensemble selon l'une des revendications précédentes, dans lequel l'ouverture (14) du composant traverse le composant (4).

4. Ensemble selon la revendication 3, dans lequel la fiche (18, 28, 29) est passée à travers l'ouverture (14) du composant.

5. Ensemble selon la revendication 4, dans lequel une partie d'extrémité (31) de la fiche (16, 28, 29) déborde au-delà du composant (4).

6. Ensemble selon la revendication 5, dans lequel pour la liaison en correspondance géométrique, une partie d'extrémité (31) de la fiche (29) est disposée de telle sorte que la partie d'extrémité soit en contact avec le côté supérieur du composant (4) ou avec un circuit (8, 10) disposé sur ce côté supérieur (33).

7. Ensemble selon la revendication 6, dans lequel le composant (4) est serré entre la partie d'extrémité (31) de la fiche (29) et le corps massif (26).

8. Ensemble selon l'une des revendications 5 à 7, dans lequel la partie d'extrémité (31) présente un bec qui déborde de la fiche (29) ou un collet qui déborde de la fiche.

9. Ensemble selon l'une des revendications précédentes, dans lequel la fiche (18, 28, 29) présente un creux (20, 30) sur son côté frontal.

10. Ensemble selon la revendication 9, dans lequel le creux (20, 30) est une ouverture (30) traversant le corps massif (6, 26).

11. Ensemble selon la revendication 10, dans lequel l'ouverture de passage (30) se rétrécit, en particulier depuis le côté du corps massif (6, 26) opposé à la fiche (18, 28).

12. Ensemble selon l'une des revendications 9 à 11, dans lequel le creux (20, 30) est évasé sur le côté frontal de la fiche.

13. Ensemble selon l'une des revendications 9 à 12, comprenant une pâte élastique (36) coulée dans le creux (20, 30).

14. Ensemble selon la revendication 13, dans lequel le corps massif (6, 26), la fiche (18, 28) et le composant électrique (4) sont entourés au moins en partie par la pâte élastique (36).

15. Ensemble selon l'une des revendications précédentes, dans lequel le corps massif (6, 26) est une résistance électrique de dérivation du circuit.

16. Ensemble selon l'une des revendications précédentes, dans lequel, dans une vue en plan sur l'ensemble (2, 24), une surface du corps massif (6, 26) a la même taille ou une taille plus grande qu'une surface du composant (4).

17. Ensemble selon l'une des revendications précédentes, dans lequel la fiche (18, 28) présente un volume dont la forme a un caractère coupant.

18. Capteur électronique de batterie comprenant
un ensemble (2, 24) selon l'une des revendications précédentes,
le corps massif (6, 26) présentant une résistance de dérivation et
le circuit (8, 10) étant prévu pour déterminer l'état de charge d'une batterie raccordée au capteur électronique (38) de batterie sur la base d'un courant électrique saisi aux bornes de la résistance de dérivation.

19. Procédé de fabrication d'un ensemble (2, 24) selon la revendication 1, comprenant un corps massif (6, 26) électriquement conducteur et un composant (4) doté d'un circuit électrique (8, 10) et d'une ouverture (14) dans le composant, le procédé comportant les étapes qui consistent à :
former (48) le composant (4) qui porte le circuit (8, 10) et doté de l'ouverture (14),
former (50) le corps massif (6, 26) avec une fiche (18, 28, 29) qui est formée d'un seul tenant avec le corps massif (6, 26) et qui en déborde et
relier (52) le composant (4) au corps massif (6, 26) par une liaison en correspondance mécanique, en particulier une liaison comprimée, et/ou par une liaison en correspondance géométrique entre le composant (4) et la fiche (18, 28, 29) par l'intermédiaire de l'ouverture (14) du composant.
